(19) Europäisches Patentamt
European Patent Office
Office européen des brevets

(11) **EP 0 479 078 B1**

(12) **EUROPÄISCHE PATENTSCHRIFT**

(45) Veröffentlichungstag und Bekanntmachung des Hinweises auf die Patenterteilung:
**04.09.1996 Patentblatt 1996/36**

(51) Int Cl.$^6$: **H03K 17/95**

(21) Anmeldenummer: **91116098.4**

(22) Anmeldetag: **21.09.1991**

(54) **Induktiver Näherungsschalter**

Inductive proximity switch

Commutateur de proximité inductif

(84) Benannte Vertragsstaaten:
**AT BE CH DE ES FR GB IT LI NL SE**

(30) Priorität: **29.01.1991 DE 4102542**
**04.10.1990 DE 4031252**

(43) Veröffentlichungstag der Anmeldung:
**08.04.1992 Patentblatt 1992/15**

(73) Patentinhaber: **Werner Turck GmbH & Co. KG**
**D-58553 Halver (DE)**

(72) Erfinder: **Tigges, Burkhard**
**W-5983 Balve (DE)**

(74) Vertreter: **Peerbooms, Rudolf, Dipl.-Phys. et al**
**Rieder & Partner**
**Anwaltskanzlei**
**Postfach 11 04 51**
**42304 Wuppertal (DE)**

(56) Entgegenhaltungen:
**EP-A- 0 265 844      EP-A- 0 371 261**
**DE-A- 1 286 099      DE-A- 3 326 476**
**DE-A- 3 814 131      US-A- 3 805 185**

Printed by Jouve, 75001 PARIS (FR)

**Beschreibung**

Die Erfindung betrifft einen induktiven Näherungsschalter mit einem Oszillator, der eine Sendespule speist, die ein magnetisches Wechselfeld erzeugt, wobei der Oszillator durch einen in das Wechselfeld eindringenden metallischen Auslöser in seinem Schwingungszustand beeinflußt wird, und mit einer Auswerteschaltung zur Gewinnung eines Schaltsignals aus der Änderung des Schwingungszustandes.

Es sind verschiedene Verfahren zur Erfassung der Annäherung eines leitfähigen Auslösers bekannt.

Beim Wirbelstromverfahren werden die durch einen Auslöser in einem magnetischen Wechselfeld hervorgerufenen Wirbelstromverluste ausgewertet. Es wird dabei das Wechselfeld meist von einem Oszillator mit LC-Schwingkreis erzeugt, welcher auf die Wirbelstromverluste mit verminderter Güte reagiert. Die daraus resultierende Änderung der Schwingungsamplitude wird bei Erreichen eines Schaltkriteriums von einer Auswerteschaltung dazu benutzt, einen Lastschalter anzusteuern. Derartige induktive Näherungsschalter sind in zahlreichen Varianten, z.B. durch die DE-AS 1 286 099, bekannt. Als nachteilig erweist sich bei diesem Verfahren, daß unterschiedlich leitende Auslöser zu unterschiedlich großen Wirbelstromverlustenund somit zu unterschiedlichen Ansprechabständen des Näherungsschalters führen. Es reduziert sich der Ansprechabstand z.B. um den Reduktionsfaktor 1/2 bis 1/3 bei Buntmetallen gegenüber magnetischen Stählen. Bei diesem Verfahren kommt es neben den "gewollten" Verlusten auch zu "parasitären" Verlusten, z.B. Verlusten durch den Wicklungswiderstand oder im Ferritmaterial und in der Vergußmasse, welche in hohem Maß von der Umgebungstemperatur abhängig sind. Bei derartigen, durch die EP-OS 0 070 796 und DE-OS 3 814 131 bekannten Näherungsschaltern sind spezielle Maßnahmen zur Verringerung der Temperaturabhängigkeit getroffen, die jedoch mit einem erheblichen technischen Schaltungsaufwand verbunden sind.

Ferner ist bereits vorgeschlagen worden, bei einem Näherungsschalter einen materialabhängigen Ansprechabstand dadurch zu vermeiden, daß das geänderte Durchlaßverhalten eines LC-Kreises in Abhängigkeit von der Frequenz als Maß für die Annäherung des Aulösers genommen wird. Neben den Wirbelstromverlusten wird dabei auch die Induktivitätsänderung der Spule ausgewertet. Bei richtiger Bauteildimensionierung, insbesondere bei Verwendung hochstabiler Komponenten, gelingt es, gleiche und nahezu temperaturunabhängige Ansprechabstände für Eisen- und Nichteisenmetalle zu erzielen. Temperaturunabhängige Ansprechabstände, die über den Spulendurchmesser hinausgehen, sind über einen großen Temperaturbereich damit aber nicht zu erreichen.

Schließlich ist es durch die DE-OS 3 840 532 bei induktiven Näherungsschaltern bekannt, über zwei räumlich getrennte Sensorspulen die komplexe Verlustleistung im Wechselfeld selbst zu messen und auszuwerten. Durch dieses Verfahren werden zwar die Einflüsse parasitärer Verluste auf den Ansprechabstand vermieden, jedoch erweist sich die direkte Messung des Sensorsignals über unbelastete Feldmeßspulen als sehr störempfindlich gegenüber elektromagnetischen Störungen. Ferner ist der schaltungstechnische Aufwand zur dort erforderlichen mathematischen Verknüpfung eines zusätzlich notwendigen Referenzsignals mit dem Sensorsignal sehr groß.

Der Erfindung liegt die Aufgabe zugrunde, einen induktiven Näherungsschalter zu schaffen, der nur einen geringen Herstellungsaufwand erfordert und einen gegenüber dem Spulendurchmesser großen, über einen weiten Temperaturbereich von beispielsweise -25°C bis +100°C konstanten Ansprechabstand aufweist. Ferner soll der Näherungsschalter sowohl als Allmetallschalter, der auf Auslöser an Eisen- und Nichteisenmetallen bei demselben Ansprechabstand anspricht oder auch als selektiver Schalter, der entweder nur auf Eisen- oder Nichteisenmetalle anspricht, auslegbar sein.

Ausgehend von einem gattungsgemäßen, z.B. durch die DE-AS 1 286 099 bekannten Näherungsschalter, wird die Aufgabe erfindungsgemäß dadurch gelöst, daß im Wechselfeld zwei Sensorspulen in unmittelbarer Differenzschaltung zur Erfassung der Differenz der in den beiden Sensorspulen induzierten Spannungen angeordnet sind, daß die Sensorspulen durch ihre räumliche Lage zueinander und durch die jeweiligen Windungszahlen derart ausgebildet sind, daß die Differenzwechselspannung beim gewünschten Ansprechabstand zu null wird, und daß die Differenzwechselspannung an den Eingang des Oszillatorverstärkers zurückgeführt ist derart, daß bei einer Differenzwechselspannung null der Oszillator seinen Schwingungszustand sprunghaft ändert.

Bei einem Näherungsschalter nach der Erfindung sind die in den beiden Sensorspulen induzierten Spannungen ein Maß für die jeweilige magnetische Durchflutung, die durch das von der Sendespule ausgehende Wechselfeld erzeugt wird. Bei einem hochohmigen Abgriff sind diese Spannungen dem magnetischen Fluß am Ort der entsprechenden Sensorspule proportional, und die Differenz der induzierten Spannungen, im folgenden Differenzwechselspannung genannt, ist dem Gradienten des Flusses proportional. Bei Eindringen eines leitfähigen Auslösers in das Wechselfeld werden in dem Auslöser Ringströme hervorgerufen, die ihrerseits ein Magnetfeld aufbauen, das dem erzeugenden Wechselfeld entgegengerichtet ist. Proportional zu der dadurch hervorgerufenen Änderung des Gradienten ändert sich auch die Differenzwechselspannung. Da bei ausreichend hochfrequenten Wechselfeldern und für Annäherungsabstände eines Auslösers, die groß gegenüber dem Durchmesser der Sendespule sind, die Änderung des Gradienten nahezu unabhängig von der Materialart des Auslösers ist, ist auch die Differenzwechselspannung unabhängig von der Materialart des Auslösers, wodurch der Ansprechabstand des Näherungsschalters in weiten Bereichen nicht mehr von der Leitfähigkeit des Auslösers abhängt.

Im unbeeinflußten Zustand hängt die Größe der in den Sensorspulen induzierten Spannungen ab von der räumlichen Anordnung der Sensorspulen und ihren jeweiligen Windungszahlen sowie von der Feldstärke und der Frequenz des sie durchflutenden Wechselfeldes. Um den Temperatureinfluß auf die Größen Feldstärke und Frequenz zu eliminieren, sind bei der Erfindung die räumlichen Lagen der Sensorspulen und ihre Windungszahlen derart aufeinander abgestimmt, daß bei dem jeweils gewünschten Ansprechabstand die Differenzwechselspannung null wird. Zudem ist vorteilhafterweise der erforderliche Schaltungsmehraufwand sehr gering, da wegen der Ausnutzung des Oszillators als Vorab-Auswertestufe zusätzlich zu ohnehin bei üblichen Näherungsschaltern vorhandenen Bauteilen nur die beiden Sensorspulen und eine gewisse Anpassung des Oszillatorverstärkers erforderlich sind, wobei die Stabilität des Oszillators sogar nur geringen Anforderungen genügen muß.

Nach einer ersten Ausführungsform der Erfindung kann vorgesehen werden, daß die Sendespule als Induktivität des LC-Schwingkreises des Oszillators geschaltet ist, daß der Eingang des Oszillatorverstärkers hochohmig ist und daß die beiden Sensorspulen mit entgegengesetzter Polarisierung in Reihe zwischen einem Spannungsteiler und dem hochohmigen Eingang des Verstärkers geschaltet sind.

Es entsteht so eine Oszillatorschaltung, die auf zwei verschiedene Arten arbeiten kann :

In einer ersten Betriebsart kann die Differenzwechselspannung den Oszillatorverstärker so ansteuern, daß die Schwingbedingung des Oszillators im unbeeinflußten Zustand erfüllt ist. Bei einer Annäherung eines Auslösers fällt die Differenzwechselspannung ab, bis sie beim gewünschten Ansprechabstand den Wert null annimmt. Bei diesem Schaltkriterium reißen die Schwingungen ab, was von der Auswertestufe festgestellt und in ein Schaltsignal für den Lastschalter umgewandelt wird. Bei weiterer Annäherung des Auslösers würde der Betrag der Differenzwechselspannung wieder ansteigen, ist aber in seiner Phasenlage gegenüber dem vorherigen Zustand um 180° gedreht, so daß die Schwingbedingung nicht erfüllt wird. Erst wenn der Auslöser sich wieder aus dem Ansprechbereich entfernt hat, schwingt der Oszillator wieder an und baut erneut ein Wechselfeld auf.

In einer zweiten Betriebsart kann der Oszillatorverstärker von der Differenzwechselspannung so angesteuert werden, daß im unbeeinflußten Zustand die Schwingungsbedingung nicht erfüllt wird und der Oszillator erst nach dem, bei überschreiten des Ansprechabstandes durch den Auslöser bewirkten, Phasenwechsel der Differenzwechselspannung zu schwingen beginnt.

Die erste Betriebsart weist gegenüber der zweiten den Vorteil auf, daß der Oszillator beim Aufbau des Wechselfeldes nicht durch die Wirbelstromverluste, die durch einen sehr nahen Auslöser bewirkt werden, zusätzlich belastet wird, so daß er insgesamt leistungsärmer ausgelegt werden kann. Vorteilhafterweise wird bei beiden Betriebsarten das Schwingungsverhalten des Oszillators bei ausreichend großem Verstärkungsfaktor des Oszillatorverstärkers ausschließlich von dem Nulldurchgang der Differenzwechselspannung bestimmt und nicht von den Eigenschaften der Sendespule oder des Oszillatorverstärkers. Der Ansprechabstand des Näherungsschalters hängt bei vorgegebenen Sensorspulen allein von der räumlichen Lage der Sensorspulen ab, wodurch die Temperaturabhängigkeit der elektrischen Bauteile ohne Einfluß auf den Ansprechabstand bleibt.

Zur Gewinnung der notwendigen Differenzwechselspannung werden die zwei Sensorspulen in unmittelbarer Differenzschaltung betrieben, d.h. sie sind in Reihe geschaltet, wobei aber die Wicklungen gegenläufig sind, wodurch es zu einer Phasenverschiebung von 180° zwischen den induzierten Spannungen kommt und so über die in Reihe geschalteten Spulen die Differenzwechselspannung direkt abgreifbar anliegt.

Die Gewinnung des Schaltsignals erfolgt in bekannter Weise durch die Abfrage der Oszillatoramplitude mit Hilfe einer Auswerteschaltung, die ihrerseits einen Lastschalter ansteuert. Hierbei erweist sich die große Störsicherheit der Anordnung durch das frequenzselektive Verhalten und die integrierende Wirkung des Oszillators als vorteilhaft.

Gemäß einer bevorzugten Ausführungsform der Erfindung kann vorgesehen werden, daß der Oszillatorverstärker ein zweistufiger Transistorverstärker mit einem Eingangstransistor und einem Ausgangstransistor ist, daß die Sendespule als Induktivität des LC-Schwingkreises des Oszillators geschaltet ist und im Kollektorkreis des Ausgangstransistors liegt und daß die beiden Sensorspulen mit entgegengesetzter Polarisierung in Reihe zwischen die Basis des Eingangstransistors und den Emitter des Ausgangstransistors geschaltet sind.

Auch die bevorzugte Ausführungsform des Näherungsschalters kann in den vorbeschriebenen zwei Betriebsarten arbeiten. Es erweist sich dabei von Vorteil, daß bereits mit einem einfachen, zweistufigen Transistorverstärker eine ausreichend große Verstärkung erzielt wird, so daß das Schwingverhalten des Oszillators ausschließlich von dem Nulldurchgang der Differenzwechselspannung bestimmt wird und nicht von den Eigenschaften der Sendespule oder des Oszillatorverstärkers. Darüber hinaus kann ein, aus zusätzlichen Widerständen aufgebauter Spannungsteiler dadurch vermieden werden, daß die zwei Sensorspulen, die in Reihe, aber mit gegenläufigen Wicklungen angeordnet sind, zwischen die hochohmige Basis des Eingangstransistors und den Emitter des Ausgangstransistors geschaltet sind. Die vorhandenen Bauteile der zweiten Transistorverstärkerstufe bilden dabei einen entsprechenden Spannungsteiler.

Für das Ansprechverhalten des Näherungsschalters auf einen Auslöser ist die Betriebsfrequenz des Oszillators von entscheidender Bedeutung. Wird der Oszillator in Ausgestaltung der Erfindung auf eine Betriebsfrequenz von mehr als 20 kHz, vorzugsweise zwischen 50 kHz (Kilohertz) und 1 MHz (Megahertz) ausgelegt und werden die Sensorspulen durch ihre räumliche Lage zueinander und durch die jeweiligen Windungszahlen derart ausgebildet, daß die Differenzwechselspannung sowohl bei einem Auslöser aus FE- als auch NE-Metall bei gleichem Schaltabstand zu null wird, liegt ein sogenannter Allmetallschalter vor.

Überraschenderweise läßt sich mit einem Näherungsschalter nach der Erfindung auch ein ausgezeichnetes selektives Schaltverhalten erreichen, d.h. ein Ansprechen nur auf Nichteisenmetalle, kurz NE-Metalle, oder aber ein Ansprechen nur auf Eisenmetalle, kurz FE-Metalle, indem die Betriebsfrequenz des Oszillators geändert wird.

So kann zunächst ein selektives Schaltverhalten der Erfindung zufolge dadurch erreicht werden, daß der Oszillator auf eine Betriebsfrequenz zwischen vorzugsweise 1 kHz und 10 kHz ausgelegt ist und die Sensorspulen durch ihre räumliche Lage zueinander und durch die jeweiligen Windungszahlen derart ausgebildet sind, daß die Differenzwechselspannung nur bei Annäherung eines FE-Auslösers bis zum gewünschten Schaltabstand zu null wird, während die Differenzwechselspannung über den gesamten möglichen Anfahrbereich des Auslösers hinweg bei Annäherung eines NE-Metallteils nie zu null wird.

Umgekehrt kann aber auch erreicht werden, daß die Differenzwechselspannung nur bei Annäherung eines NE-Auslösers, nicht aber bei Annäherung eines FE-Auslösers, zu null wird, indem der Oszillator wiederum auf eine Betriebsfrequenz zwischen vorzugsweise 1 kHz und 10 kHz ausgelegt wird und eine geeignete räumliche Lage der beiden Sensorspulen und geeignete Windungszahlen für die Sensorspulen vorgesehen werden.

Ursächlich für das unterschiedliche Verhalten des Näherungsschalters entsprechend der Betriebsfrequenz des Oszillators sind die frequenzabhängige Permeabilität von z.B. Eisen und die aus der unterschiedlichen Eindringtiefe resultierenden, bei verschiedenen Materialarten unterschiedlichen Feldänderungen. So ist z.B. die Permeabilität von Eisen bei niedrigen Frequenzen zunächst groß, sinkt aber oberhalb einer bestimmten Frequenz stark ab. Elektrisch leitfähige Auslöser haben die Eigenschaft, das Feld vom leitfähigen Material gleichsam wegzudrängen, während magnetische leitfähige Auslöser das Feld gleichsam in den Auslöser hineinziehen. So überwiegt bei ausreichend niedriger Betriebsfrequenz auch bei Eisen der Effekt des "Hineinziehens" gegenüber dem Feldverdrängungseffekt. Bei verlustarmen Magnetwerkstoffen, z.B. Ferriten, gibt es nur den Effekt des "Hineinziehens". FE-Metalle führen also zu einer Feldverstärkung im Raum zwischen Sendespule und Auslöser, NE-Metalle zu einer Feldschwächung. Es ist daher möglich, Sensorspulen durch entsprechende Anpassung in ihrer räumlichen Lage zueinander und der entsprechenden Windungszahlen derart auszubilden, daß der Oszillator seinen Schwingungszustand nur bei Annäherung von NE-Auslösern oder nur bei Annäherung von FE-Auslösern ändert.

In Weiterbildung der Erfindung kann vorgesehen werden, daß die Sendespule und die beiden Sensorspulen als Luftspulen koaxial auf einem gemeinsamen Spulenkörper aus Kunststoff oder Keramik angeordnet sind. Hierdurch ist es möglich, den Näherungsschalter mit seiner der Ansprechseite gegenüberliegenden Rückseite auf einer Metallwand anzuordnen, ohne daß hierdurch der Ansprechabstand merklich verändert wird. Eventuelle Änderungen beim Ansprechabstand können korrigiert werden, wenn nach weiteren Merkmalen der Erfindung die Sendespule mittig und verschiebbar zwischen den Sensorspulen angeordnet wird. Bei Bedarf kann sogar in Abhängigkeit von der rückseitigen Beeinflussung der Ansprechabstand näher an die Metallwand heran verlegt werden, da eine Luftspulenanordnung durch große Spulenabstände große Differenzwechselspannungen ermöglicht, wodurch die Empfindlichkeit des Näherungsschalters erheblich gesteigert wird.

Bei großen Ansprechabständen treten geringe Temperaturabhängigkeiten aufgrund thermisch bedingter Ausdehnung der Spulenträger auf. Zur Vermeidung einer solchen Änderung des Ansprechabstandes kann der Erfindung zufolge vorgesehen werden, in das Feld der Sensorspulen magnetisches Material mit bekanntem temperaturabhängigen Permeabilitätsverhalten zur Kompensation der bei großen Spulenabständen auftretenden Temperaturdriften einzubringen. Dabei hat es sich als vorteilhaft erwiesen, das magnetische Material in eine Ausnehmung des Spulenkörpers im Bereich der dem Auslöser abgewandten Sensorspule, z.B. mit einer Oberfläche von 4 mm$^2$ bei einem Spulendurchmesser von 30 mm, anzubringen.

Darüber hinaus erweist sich der Näherungsschalter mit einer Luftspulenanordnung als geeignet zum Einsatz in Schweißanlagen, d.h. als störunempfindlich gegenüber äußeren Magnetfeldern, da kein Ferritkern mehr vorliegt, der bei Sättigung durch äußere Magnetfelder sonst das Schaltverhalten des Näherungsschalters ungünstig beeinflussen könnte. Auch eine Beeinflussung des Ansprechabstandes durch Alterung des Ferritkernes entfällt.

Bei einem bündigen Einbau des Näherungsschalters nach der Erfindung kann in bekannter Weise vorgesehen werden, die Spulenanordnung in einer, zum Auslöser hin offenen Metall-Abschirmung anzuordnen. Diese an sich bekannte Abschirmmaßnahme kann auch in Form eines Metallzylinders ausgeführt werden. Hierbei ist es möglich, solche Abschirm-Metallbecher und Zylinder mehrschichtig auszuführen, wobei die einzelnen Metallschichten unterschiedliches magnetisches Verhalten aufweisen.

Ferner kann der Erfindung zufolge vorgesehen werden, daß auf der offenen Seite der Metall-Abschirmung eine Kompensationsspule konzentrisch so angeordnet und mit der Sendespule in Serie geschaltet ist, daß die Stromrichtung in der Kompensationsspule der Stromrichtung in der Sendespule entgegengesetzt ist. Dabei beträgt vorteilhafter Weise das Produkt aus Windungszahl n und dem Strom I der Kompensationsspule etwa 5 Prozent des Produktes n x I der Sendespule. Durch diese Maßnahmen wird das Magnetfeld der Sendespule quasi gerichtet und von der Einbauwand

EP 0 479 078 B1

ferngehalten.

Neben der rückseitigen Montage des Näherungsschalters auf Metallflächen oder einem bündigen Einbau in Metallflächen werden von Anwendern weitere Anwendungsmöglichkeiten von Näherungsschaltern verlangt. So werden Näherungsschalter mit stets gleichbleibend großem Ansprechabstand auch unter besonders rauhen Umgebungsbedingungen, wie hohen Drücken, hohen Temperaturen und in Flüssigkeiten sowie in explosionsgeschützten Ausführungen gefordert. Um diesen Forderungen zu entsprechen kann der Erfindung zufolge vorgesehen werden, daß die Spulen in einem einstückigen, zum Auslöser hin geschlossenen, topfförmigen Metallgehäuse angeordnet sind. Hierdurch ergibt sich der Vorteil, daß die Schwingkreisgüte bei der Auswertung nur eine untergeordnete Rolle spielt, so daß das Erkennen eines metallischen Auslösers auch durch eine dicke Metallwand hindurch möglich wird. Damit das von der Sendespule abgehende, den Boden des topfförmigen Gehäuses durchsetzende Magnetfeld möglichst wenig geschwächt wird, ist der Erfindung zufolge ferner vorgesehen, daß bei einer Oszillatorfrequenz zwischen 1 kHz und 10 kHz die Wandstärke des Metallgehäuses im Bereich des zum Auslöser hin austretenden Feldes kleiner als die Skintiefe ist. Dies wird insbesondere dann erreicht, wenn das Metallgehäuse aus einem elektrisch schlecht leitenden Metall geringer Permeabilität besteht, z.B. Titan, V2A- oder V4A-Stahl.

Entsprechend kann ein Näherungsschalter nach der Erfindung in offener Ausführung auch durch relativ dicke metallische Wände hindurch auf einen Auslöser ansprechen. Der Näherungsschalter nach der Erfindung weist in seinem Ansprechverhalten bezüglich des Auslösermaterials als auch hinsichtlich seines nahezu temperaturunabhängigen Ansprechabstandes erhebliche Verbesserungen gegenüber bekannten Näherungsschaltern auf.

Der Näherungsschalter nach der Erfindung kann so empfindlich ausgelegt werden, daß er auf kleinste Lageänderungen eines, beispielsweise auf einem beweglichen Druck- oder Temperaturfühler montierten, Auslösers anspricht, so daß er auch als Druck- oder Temperaturwächter einsetzbar ist.

Weitere räumliche Anordnungen der Sende- und der beiden Sensorspulen sind in den Unteransprüchen angegeben. Der Gegenstand der Erfindung wird anhand der Zeichnung näher erläutert, in der zeigen :

Fig. 1 ein Schaltungsbild einer ersten Ausführungsform eines Näherungsschalters nach der Erfindung,

Fig. 2 bis Fig. 9 verschiedene räumliche Anordnungen der Sende- und Sensorspulen des Näherungsschalters,

Fig.10 eine mit Abschirmungen versehene Spulenanordnung zum bündigen Einbau des Näherungsschalters in eine Metallwand,

Fig.11 eine druckfeste und explosionsgeschützte Ausführungsform,

Fig.12 ein Schaltbild einer bevorzugten Ausführungsform des Oszillators und

Fig.13 eine schematische Darstellung zum Ausführungsbeispiel nach Fig. 8.

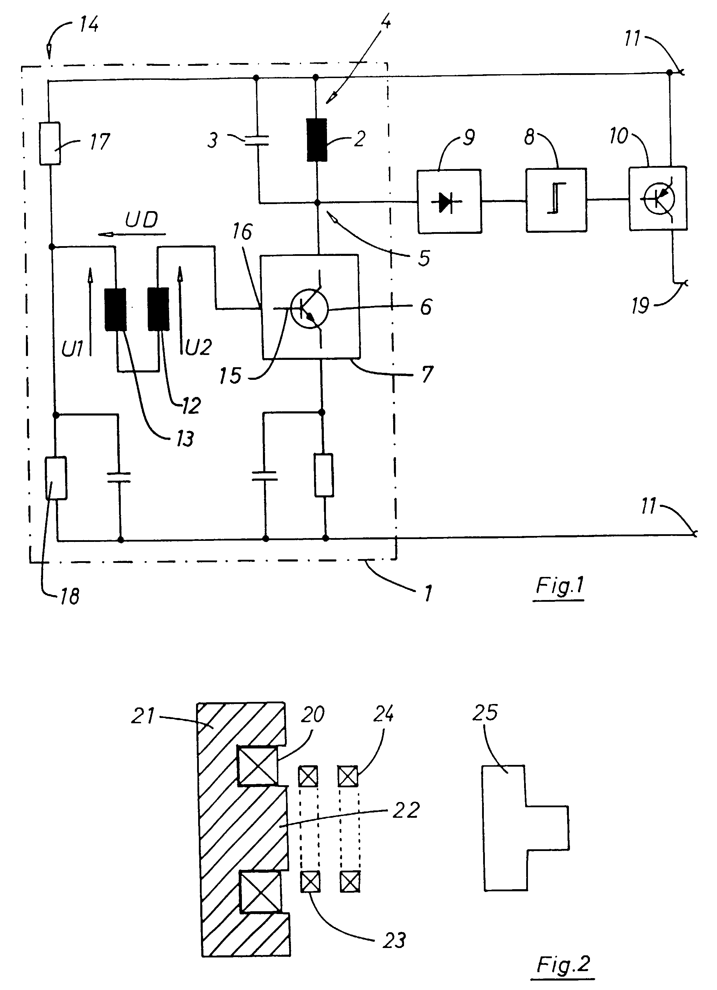

Bei dem Näherungsschalter nach Fig. 1 wird von einem Oszillator 1 über eine Sendespule 2, die als Induktivität zusammen mit einem Kondensator 3 einen LC-Schwingkreis 4 des Oszillators 1 bildet, ein Wechselfeld erzeugt. Der LC-Schwingkreis 4 liegt in dem Kollektorkreis 5 eines Verstärkertransistors 6, der bei geringen Anforderungen an den Näherungsschalter bereits als Oszillatorverstärker 7 ausreicht.

Der Schwingungszustand des Oszillators wird von einer Auswerteschaltung 8 über eine Gleichrichterschaltung 9 am Kollektorkreis 5 abgegriffen und von ihr in ein binäres Schaltsignal für einen Lastschalter 10 umgewandelt. Der Oszillator 1, die Gleichrichterschaltung 9 und die Auswerteschaltung 8 werden über die Anschlüsse 11 mit Strom versorgt.

Im Wechselfeld der Sendespule 2 befinden sich zwei Sensorspulen 12, 13 in unmittelbarer Differenzschaltung zwischen einem Spannungsteiler 14 und der Basis 15 des Verstärkertransistors 6 bzw. dem hochohmigen Eingang 16 des Oszillatorverstärkers 7. Die Widerstände 17, 18 sowie die im Emitterkreis liegende RC-Kombination legen den Arbeitspunkt des Transistors fest. Die Differenzwechselspannung UD, die sich aus der Differenz der in den Sensorspulen induzierten Spannungen U1 und U2 ergibt, steuert das Schwingungsverhalten des Oszillators 1.

Sein Schwingungszustand wird von der Auswerteschaltung 8 festgestellt, die entsprechend den Lastschalter 10 ansteuert, der eine in seinem Lastkreis 19 liegende, nicht dargestellte Last schaltet.

Die Fig. 2 bis Fig. 5 und Fig. 7 zeigen verschiedene räumliche, koaxiale Anordnungen von Sendespule und Sensorspulen.

In Fig. 2 ist die Sendespule 20 in einem Ferrittopf 21 auf einem Mittelbutzen 22 angeordnet. Beide Sensorspulen 23, 24 liegen axial vor der Sendespule 20 auf der Seite des Auslösers 25.

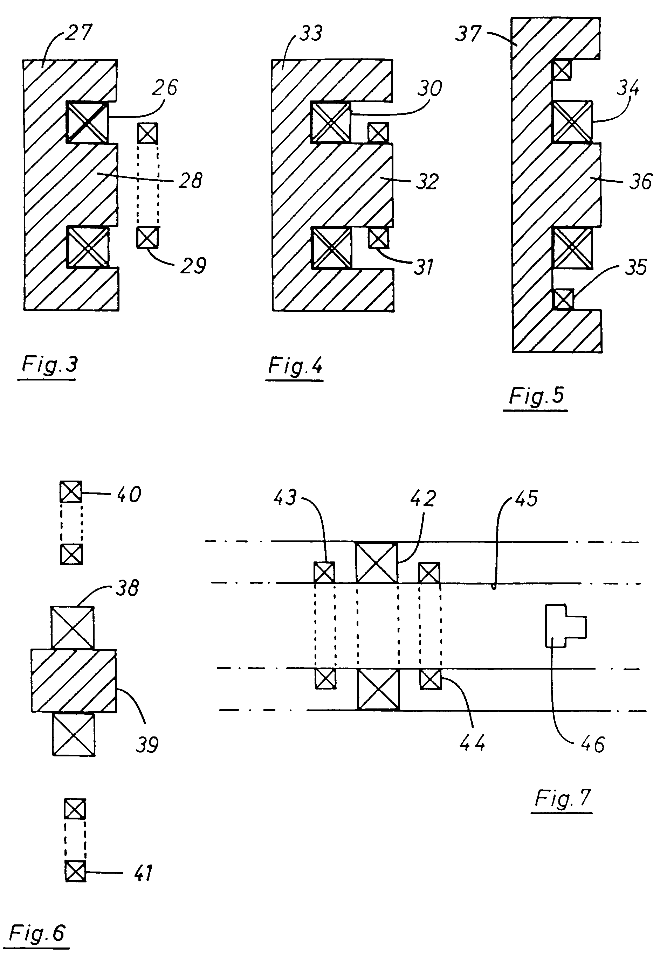

In Fig. 3 sind Sende- und eine der Sensorspulen als bifilare Wicklung 26 in einem Ferrittopf 27 auf dessen Mittelbutzen 28 angeordnet, und die andere Sensorspule 29 liegt koaxial im Wechselfeld vor der bifilaren Wicklung 26.

In Fig. 4 befinden sich die bifilare Wicklung 30 und die andere Sensorspule 31 koaxial hintereinander auf dem Mittelbutzen 32 des Ferrittopfes 33, während in Fig. 5 eine konzentrische Anordnung von der bifilaren Wicklung 34 auf dem Mittelbutzen 36 und der Sensorspule 35 innerhalb des Ferrittopfes 37 gezeigt ist.

Fig. 6 zeigt eine räumliche Anordnung, bei der die Sendespule 38 auf einem Ferritkern 39 mittig zwischen den beiden Sensorspulen 40, 41 angeordnet ist, wobei alle Spulen mit ihren Ringebenen in einer gemeinsamen Ebene liegen.

Fig. 7 zeigt eine koaxiale Anordnung der Sendespule 42 mittig zwischen den Sensorspulen 43, 44, wobei alle Spulen bündig mit der Innenwand eines Rohres 45 liegen, so daß der Näherungsschalter auf einen durch das Rohr und die Spulen hindurchfallenden Auslöser 46 anspricht.

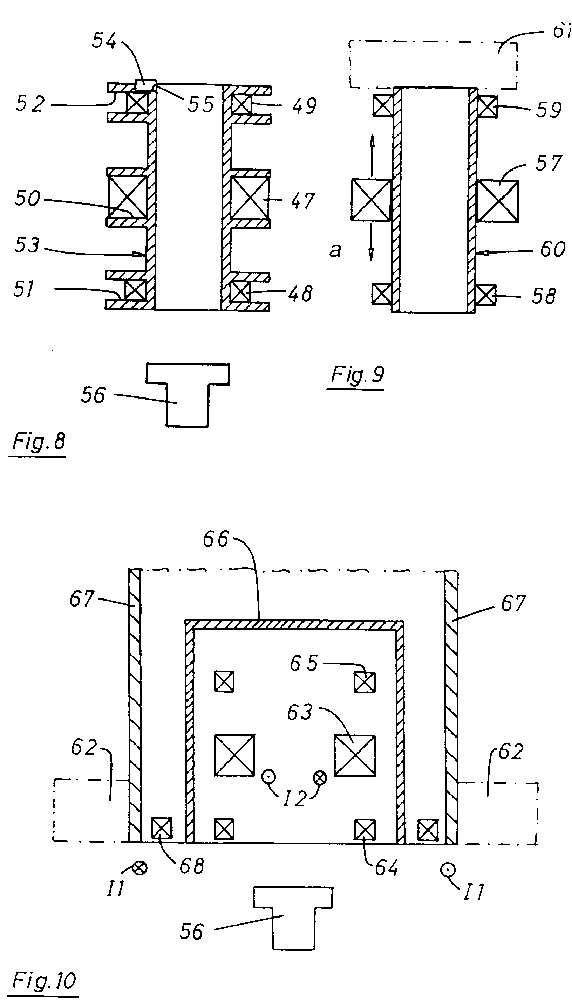

Beim Ausführungsbeispiel nach Fig. 8 sind Luftspulen verwendet, wobei die Sendespule 47 mittig zwischen den Sensorspulen 48, 49 angeordnet ist. Die drei Spulen liegen in drei Kammern 50, 51, 52 eines gemeinsamen nichtferritischen Spulenkörpers 53, z.B. aus Keramik oder Kunststoff. Ferner ist hier die Anordnung eines magnetischen Materialteiles 54 in einer Ausnehmung 55 des Spulenkörpers 53 im Bereich der dem Auslöser 56 abgewandten Sensorspule 49 gezeigt. Durch das magnetische Materialteil 54 wird eine temperaturbedingte Relativbewegung zwischen den verhältnismäßig weit auseinander liegenden Spulen 47, 48, 49 kompensiert.

In Fig. 9 ist die mittig angeordnete Sendespule 57 auf einem für Sendespule 57 und Sensorspulen 58,59 gemeinsamen Spulenkörper 60 in Pfeilrichtung a verschiebbar. Hierdurch ist es möglich, den Einfluß einer rückwärtigen metallischen Befestigungswand 61 auf den Ansprechabstand des Näherungsschalters auszugleichen.

Fig. 10 zeigt einen zum bündigen Einbau in eine metallische Einbauwand 62 geeigneten Näherungsschalter, bei dem die Sendespule 63 koaxial zwischen den Sensorspulen 64, 65 angeordnet ist und die gesamte Spulenanordnung in einer zum Auslöser 56 hin offenen Metall-Abschirmung 66 liegt. Zwischen der Metall-Abschirmung 66 und dem Sensorgehäuse 67 ist an der Ansprechseite als weitere Abschirmmaßnahme eine Kompensationsspule 68 zur Abschirmung und zur Bündelung des austretenden Feldes der Sendespule 63 gezeigt. Die Richtung des Stromes I 1 in der Kompensationsspule 68 ist der Richtung des Stromes I 2 der Sendespule 63 entgegengesetzt.

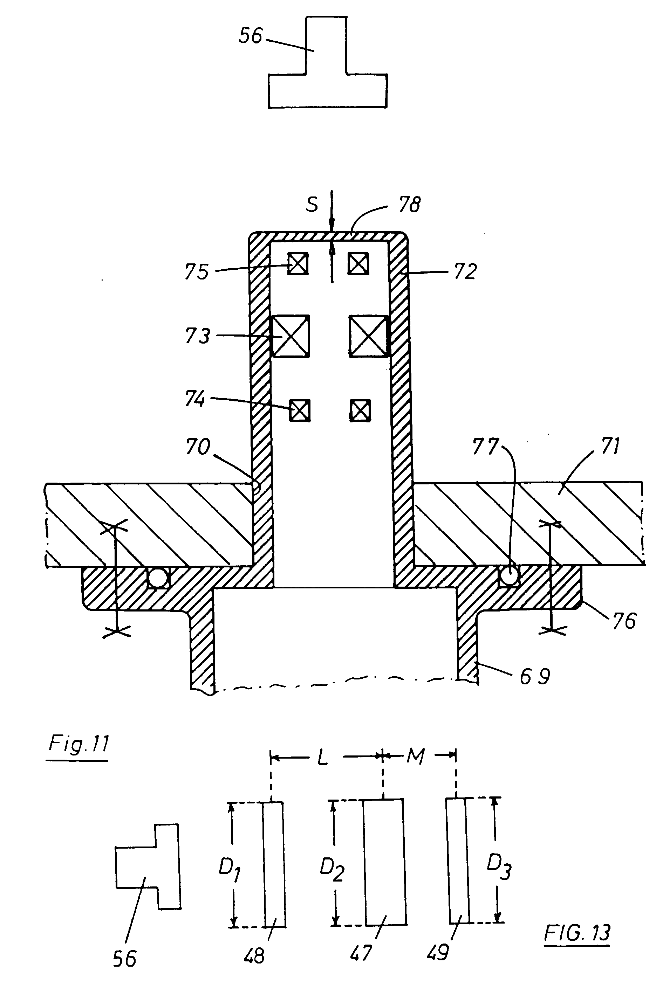

In Fig. 11 ist eine druckfeste und explosionsgeschützte Ausführungsform des Näherungsschalters beschrieben. Das Gehäuse 69 des Näherungsschalters weist einen im Durchmesser kleineren, durch einen Durchbruch 70 in der Befestigungswand 71 hindurchgesteckten Sensorkopf 72 auf, in dem die Spulen 73, 74, 75 koaxial angeordnet sind. Zwischen Befestigungswand 71 und einer Ringschulter 76 des Gehäuses ist ein Dichtring 77 eingespannt. Bei der Wand 71 kann es sich um die Wandung eines Druckbehälters handeln, in den der Sensorkopf 72 hineinragt.

Bei druckfesten und explosionsgeschützten Näherungsschaltern mit topfförmigem Ganzmetallgehäuse nach der Erfindung ist die Stärke S der stirnseitigen, vom Feld der Sendespule 73 durchsetzten Metallwand 78 erheblich kleiner als die Skintiefe bei der gegebenen Betriebsfrequenz. Dies wird bei einer Frequenz zwischen 1 kHz bis 10 kHz insbesondere dadurch erreicht, daß für das Gehäuse 69 ein schlecht leitendes Metall mit geringer Permeabilität wie Titan oder unmagnetische Stähle verwendet wird.

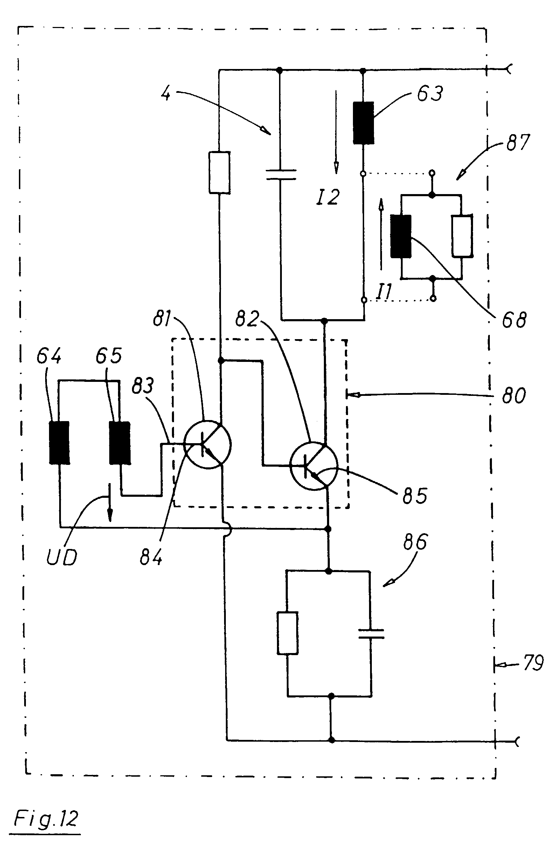

Fig. 12 zeigt einen bevorzugten Schaltungsaufbau des Oszillators 79 des Näherungsschalters nach der Erfindung. Der Oszillatorverstärker 80 ist als zweistufiger Transistorverstärker mit einem Eingangstransistor 81 und einem Ausgangstransistor 82 ausgeführt. Der hochohmige Eingang 83 des Ozillatorverstärkers 80 wird von der Basis 84 des Eingangstransistors 81 gebildet. Die Sensorspulen 64, 65 sind in unmittelbarer Differenzschaltung zwischen Basis 84 und Emitter 85 des Ausgangstransistors 82 geschaltet. Durch diese Maßnahme entfällt der gesonderte Spannungsteiler 14 nach Fig. 1, da der Spannungsabfall einerseits über die RC-Kombination 86 und andererseits über die Verstärkerschaltung ausgenutzt wird. Die Sendespule 63 liegt im Kollektorkreis des Ausgangstransistors 82.

Bei bündig einzubauenden Näherungsschaltern (vergleiche Fig. 10) kann eine RL-Kombination 87 mit der Sendespule 63 in Serie geschaltet sein, wobei die Wicklung der Kompensationsspule 68 gegenläufig zur Wicklung der Sendespule 63 ausgeführt ist. Durch diese Maßnahme ist die Richtung des Stromes I 1 in der Kompensationsspule 68 der Richtung des Stromes I 2 in der Sendespule 63 entgegengesetzt. Bei einer Anordnung der Kompensationsspule 68 zwischen der metallischen Einbauwand 62 und der Sensorspule 64 nahe der Einbauwand 62 wird eine bessere Richtcharakteristik des magnetischen Feldes erreicht.

Anhand der schematischen Skizze nach Fig. 12, die dem Ausführungsbeispiel nach Fig. 8 entspricht, wird im folgenden der detaillierte Aufbau für einige Beispiele von Näherungsschaltern nach der Erfindung angegeben.

Beispiel 1

Allmetallschalter (FE + NE)

1. Sendespule 47 aus Kupferlackdraht mit einem Durchmesser von 0,15 mm,

2. Sensorspulen 48, 49 aus Kupferlackdraht mit einem Durchmesser von 0,1 mm,

3. Wickelquerschnitte der Spulen 47, 48, 49 kleiner als 1 mm$^2$,

4. Windungszahl von Sendespule 47 gleich 20 Windungen,

5. Windungszahl der Sensorspule 48 beträgt 12 Windungen,

6. Windungszahl der Sensorspule 49 beträgt 6 Windungen,

7. Durchmesser D1, D2, D3 der Spulen 47, 48, 49 gleich 33 mm,

8. Abstand L zwischen Sensorspule 48 und Sendespule 47 gleich 7,5 mm,

9. Abstand M zwischen Sendespule 47 und Sensorspule 49 gleich 3 mm,

10. Kapazität des Schwingkreiskondensators gleich 2200 Picofarad,

11. Abhängig vom Wickelsinn (bzw. der Polarität) der Sendespule können zwei verschiedene Arbeitsweisen des Oszillators realisiert werden:

11a Einstellung der Differenzspannung $U_D$ so, daß der Oszillator im unbetätigten Zustand schwingt; bei Annäherung des Auslösers auf den Schaltabstand reißen die Schwingungen ab.

11b Oder Einstellung der Differenzspannung $U_D$ so, daß der Oszillator im unbetätigten Zustand nicht schwingt; bei Annäherung des Auslösers auf den Schaltabstand setzen die Schwingungen ein.

Beispiel 2

Allmetallschalter (FE + NE)
wie Beispiel 1, jedoch

5a) Windungszahl der Sensorspule 48 beträgt 5 Windungen,

6a) Windungszahl der Sensorspule 49 beträgt 5 Windungen,

7a) Durchmesser $D_1$, $D_2$ der Sensorspule 48 bzw. der Sendespule 47 beträgt 33 mm, der Durchmesser der Sensorspule 49 26 mm,

Beispiel 3

NE-Schalter
wie Beispiel 1 aber

3b) die Wickelquerschnitte der Sensorspulen 48, 49 sind kleiner als 1 mm$^2$, der Wickelquerschnitt der Sendespule ca. 3 mm$^2$,

4b) die Windungszahl der Sendespule 47 beträgt 300 Windungen,

10b) die Kapazität des Schwingkreiskondensators ist gleich 0,22 Mikrofarad,

Bei Einstellung der Differenzspannung wie unter Beispiel 1, Punkt 11a und 11b, beschrieben, tritt bei Annäherung von FE-Metallen keine Veränderung des Oszillator-Schwingzustandes ein.

Beispiel 4

FE-Schalter
wie Beispiel 3, jedoch

11c) Einstellung der Differenzspannung $U_D$ so, daß der Oszillator im unbetätigten Zustand nicht schwingt, bei Annäherung von FE-Metall setzen Schwingungen ein.

oder

11d) Einstellung der Differenzspannung $U_D$ so, daß der Oszillator im unbetätigten Zustand schwingt, bei Annäherung von FE-Metall reißen Schwingungen ab.

In beiden Fällem führt die Annäherung von Ne-Metallen zu keiner Veränderung des Schwingungszustandes.

Bezugszeichenliste

| | |
|---|---|
| 1 | Oszillator |
| 2 | Sendespule |
| 3 | Kondensator |
| 4 | LC-Schwingkreis |
| 5 | Kollektorkreis |
| 6 | Verstärkertransistor |
| 7 | Oszillatorverstärker |
| 8 | Auswerteschaltung |
| 9 | Gleichrichterschaltung |
| 10 | Lastschalter |
| 1 1 | Anschlüsse |
| 12 | Sensorspule |
| 13 | Sensorspule |
| 14 | Spannungsteiler |
| 15 | Basis |
| 16 | Eingang |
| 17 | Widerstand |
| 18 | Widerstand |
| 19 | Lastkreis |
| 20 | Sendespule |
| 21 | Ferrittopf |
| 22 | Mittelbutzen |
| 23 | Sensorspule |
| 24 | Sensor spule |
| 25 | Auslöser |
| 26 | bifilare Wicklung |
| 27 | Ferrittopf |
| 28 | Mittelbutzen |
| 29 | Sensorspule |
| 30 | bifilare Wicklung |
| 31 | Sensorspule |
| 32 | Mittelbutzen |
| 33 | Ferrittopf |
| 34 | bifilare Wicklung |
| 35 | Sensorspule |
| 36 | Mittelbutzen |
| 37 | Ferrittopf |
| 38 | Sendespule |
| 39 | Ferritkern |
| 40 | Sensorspule |
| 41 | Sensorspule |
| 42 | Sendespule |
| 43 | Sensorspule |
| 44 | Sensorspule |
| 45 | Rohr |
| 46 | Auslöser |
| 47 | Sendespule |
| 48 | Sensorspule |

49  Sensorspule
50  Kammer
51  Kammer
52  Kammer
53  Spulenkörper
54  Magnetteil
55  Ausnehmuna
56  Auslöser
57  Sendespule
58  Sensorspule
59  Sensorspule
60  Spulenkörper
61  Befestigungswand
62  Einbauwand
63  Sendespule
64  Sensorspule
65  Sensorspule
66  Metall-Abschirmung
67  Sensorgehäuse
68  Kompensationsspule
69  Gehäuse
70  Durchbruch
71  Befestigungswand
72  Sensorkopf
73  Sendespule
74  Sensorspule
75  Sensorspule
76  Ringschulter
77  Dichtring
78  Metallwand
79  Oszillator
80  Oszillatorverstärker
81  Eingangstransistor
82  Ausgangstranssistor
83  Eingang
84  Basis
85  Emitter
86  RC-Kombination
87  RL-Kombination

UD  Differenzwechselspannung
U1  Spannung
U2  Spannung
a   Pfeilrichtung
S   Wandstärke

**Patentansprüche**

1.  Induktiver Näherungsschalter mit einem Oszillator (1), der eine Sendespule (2) speist, die ein magnetisches Wechselfeld erzeugt, wobei der Oszillator (1) durch einen in das Wechselfeld eindringenden metallischen Auslöser (25) in seinem Schwingungszustand beeinflußt wird, und mit einer Auswerteschaltung (8) zur Gewinnung eines Schaltsignals aus der Änderung des Schwingungszustandes, dadurch gekennzeichnet, daß im Wechselfeld zwei Sensorspulen (12, 13) in unmittelbarer Differenzschaltung zur Erfassung der Differenz der in den beiden Sensorspulen induzierten Spannungen (U1, U2) angeordnet sind, daß die Sensorspulen (12, 13) durch ihre räumliche Lage zueinander und durch die jeweiligen Windungszahlen derart ausgebildet sind, daß die Differenzwechselspannung (UD) beim gewünschten Ansprechabstand zu null wird, und daß die Differenzwechselspannung (UD) an den Eingang (16) des Oszillatorverstärkers (7) des Oszillators (1) zurückgeführt ist derart, daß bei einer Differenzwechselspannung null der Oszillator (1) seinen Schwingungszustand sprunghaft ändert.

2. Näherungsschalter nach Anspruch 1, dadurch gekennzeichnet, daß die Sendespule (2) als Induktivität des LC-Schwingkreises (4) des Oszillators (1) geschaltet ist, daß der Eingang (16) des Oszillatorverstärkers (7) hochohmig ist und daß die beiden Sensorspulen (12, 13) mit entgegengesetzter Polarisierung in Reihe zwischen einem Spannungsteiler (14) und dem hochohmigen Eingang (16) des Oszillatorverstärkers (7) geschaltet sind.

3. Näherungsschalter nach Anspruch 1, dadurch gekennzeichnet, daß der Oszillatorverstärker (80) ein zweistufiger Transistorverstärker mit einem Eingangstransistor (81) und einem Ausgangstransistor (82) ist, daß die Sendespule (63) als Induktivität des LC-Schwingkreises (4) des Oszillators (79) geschaltet ist und im Kollektorkreis des Ausgangstransistors (82) liegt und daß die beiden Sensorspulen (64, 65) mit entgegengesetzter Polarisierung in Reihe zwischen Basis (84) des Eingangstransistors (81) und Emitter (85) des Ausgangstransistors (82) geschaltet sind.

4. Näherungsschalter nach den Ansprüchen 1, 2 oder 3, dadurch gekennzeichnet, daß der Oszillator (1, 79) auf eine Betriebsfrequenz von mehr als 20 kHz, vorzugsweise zwischen 50 kHz und 1 MHz, ausgelegt ist und die Sensorspulen (12, 13) durch ihre räumliche Lage zueinander und durch die jeweiligen Windungszahlen derart ausgebildet sind, daß die Differenzwechselspannung (UD) sowohl bei einem Auslöser (25, 46, 56) aus FE- als auch NE-Metall bei gleichem Schaltabstand zu null wird.

5. Näherungsschalter nach den Ansprüchen 1, 2 oder 3, dadurch gekennzeichnet, daß der Oszillator (1, 79) auf eine Betriebsfrequenz zwischen vorzugsweise 1 kHz und 10 kHz ausgelegt ist und die Sensorspulen (12, 13; 64, 65) durch ihre räumliche Lage zueinander und durch die jeweiligen Windungszahlen derart ausgebildet sind, daß die Differenzwechselspannung (UD) nur bei Annäherung eines FE-Auslösers bis zum gewünschten Schaltabstand zu null wird, während die Differenzwechselspannung über den gesamten möglichen Auslöser-Anfahrbereich hinweg bei Annäherung eines NE-Metallteiles nie zu null wird.

6. Näherungsschalter nach den Ansprüchen 1, 2 oder 3, dadurch gekennzeichnet, daß der Oszillator (1, 79) auf eine Betriebsfrequenz zwischen vorzugsweise 1 kHz und 10 kHz ausgelegt ist und die Sensorspulen (12, 13; 64, 65) durch ihre räumliche Lage zueinander und durch die jeweiligen Windungszahlen derart ausgebildet sind, daß die Differenzwechselspannung (UD) nur bei Annäherung eines NE-Auslösers, nicht aber bei Annäherung eines FE-Metallteiles, zu null wird.

7. Näherungsschalter nach einem der Ansprüche 1 bis 6, dadurch gekennzeichnet, daß die Sendespule (20) und die beiden Sensorspulen (23, 24) koaxial zueinander angeordnet sind.

8. Näherungsschalter nach Anspruch 7, dadurch gekennzeichnet, daß die Sendespule (20) in einem Ferrittopf (21) mit Mittelbutzen (22) angeordnet ist und beide Sensorspulen (23, 24) vor dem Ferrittopf (21) auf der Seite des Auslösers (25) angeordnet sind.

9. Näherungsschalter nach Anspruch 7, dadurch gekennzeichnet, daß die Sendespule und eine der Sensorspulen bifilar gewickelt sind und daß die bifilare Wicklung (26) innerhalb des Ferrittopfes (27) angeordnet ist.

10. Näherungsschalter nach Anspruch 9, dadurch gekennzeichnet, daß die andere Sensorspule (29) vor dem Ferrittopf (27) angeordnet ist.

11. Näherungsschalter nach Anspruch 9, dadurch gekennzeichnet, daß die andere Sensorspule (35 oder 31) ebenfalls im Ferrittopf (37 oder 33) entweder konzentrisch zur bifilaren Wicklung (34) der ersten Sensorspule und der Sendespule oder axial neben der bifilaren Wicklung (30) angeordnet ist.

12. Näherungsschalter nach Anspruch 7, dadurch gekennzeichnet, daß die Sendespule (42) zwischen den beiden Sensorspulen (43, 44) innerhalb eines Rohres (45) angeordnet ist.

13. Näherungsschalter nach den Ansprüchen 1 und 6, dadurch gekennzeichnet, daß die beiden Sensorspulen (40, 41) mit ihren Ringebenen in einer Ebene liegen und daß die Sensorspulen (40, 41) die Sendespule (38) mittig zwischen sich einfassen.

14. Näherungsschalter nach Anspruch 7, dadurch gekennzeichnet, daß die Sendespule (47) und die beiden Sensorspulen (48, 49) als Luftspulen koaxial auf einem gemeinsamen Spulenkörper (53) aus Kunststoff oder Keramik angeordnet sind.

15. Näherungsschalter nach Anspruch 14, dadurch gekennzeichnet, daß die Sendespule (47) mittig zwischen den beiden Sensorspulen (48, 49) angeordnet ist.

16. Näherungsschalter nach Anspruch 15, dadurch gekennzeichnet, daß die Sendespule (57) axial verschiebbar ist.

17. Näherungsschalter nach den Ansprüchen 14, 15 oder 16, dadurch gekennzeichnet, daß in das Feld der Sensorspulen (48, 49) magnetisches Materialteil (54) mit bekanntem temperaturabhängigem Permeabilitätsverhalten zur Kompensation der bei großen Spulenabständen auftretenden Temperaturdriften eingebracht ist.

18. Näherungsschalter nach Anspruch 17, dadurch gekennzeichnet, daß das magnetische Materialteil (54) in einer Ausnehmung (55) des Spulenkörpers (53) im Bereich der dem Auslöser (56) abgewandten Sensorspule (49) angebracht ist.

19. Näherungsschalter nach Anspruch 18, dadurch gekennzeichnet, daß das magnetische Materialteil (54) eine Oberfläche von 4 mm$^2$ bei einem Spulendurchmesser von 30 mm aufweist.

20. Näherungsschalter nach einem der vorangegangenen Ansprüche 1 bis 19, dadurch gekennzeichnet, daß die Spulen (63, 64, 65) in einer zum Auslöser (56) hin offenen Metall-Abschirmung (66) angeordnet sind.

21. Näherungsschalter nach Anspruch 20, dadurch gekennzeichnet, daß auf der offenen Seite der Metall-Abschirmung (66) eine Kompensationsspule (68) konzentrisch so angeordnet und mit der Sendespule (63) in Serie geschaltet ist, daß die Richtung des Stromes (I 1) in der Kompensationsspule (68) der Richtung des Stromes (I 2) in der Sendespule (63) entgegengesetzt ist.

22. Näherungsschalter nach Anspruch 20, dadurch gekennzeichnet, daß die Windungszahl $n_K$ der Kompensationsspule (68) etwa 5 % der Windungszahl $n_S$ der Sendespule (63), multipliziert mit dem Verhältnis des Sendespulenstroms (I2) zum Kompensationsspulenstrom (I1),beträgt, d.h. $n_K = 0{,}05 \times \frac{I1}{I2} \times n_S$.

23. Näherungsschalter nach einem der vorangegangenen Ansprüche 1 bis 22, dadurch gekennzeichnet, daß die Spulen (73, 74, 75) in einem einstückigen, zum Auslöser (56) hin geschlossenen, topfförmigen Metallgehäuse (69) angeordnet sind.

24. Näherungsschalter nach Anspruch 23, dadurch gekennzeichnet, daß bei einer Oszillatorfrequenz zwischen 1 kHz und 10 kHz die Wandstärke (S) des Metallgehäuses (69) im Bereich (78) des zum Auslöser (56) hin austretenden Feldes kleiner als die Skintiefe bei gegebener Betriebsfrequenz ist.

25. Näherungsschalter nach Anspruch 24, dadurch gekennzeichnet, daß das Metallgehäuse (69) aus einem elektrisch schlecht leitenden Metall geringer Permeabilität besteht, z.B. aus Titan, V2A- oder V4A-Stahl.

**Claims**

1. Inductive proximity switch having an oscillator (1) which feeds a transmitting coil (2) which generates an alternating magnetic field, the oscillation state of the oscillator (1) being affected by a metallic tripping device penetrating into the alternating field, and having an evaluating circuit (8) for obtaining a switching signal from the change in oscillation state, characterised in that in the alternating field two sensor coils (12, 13) are arranged in direct differential connection for detecting the difference in the voltages (U1, U2) induced in both sensor coils, that the sensor coils (12, 13) are constructed by means of their spatial position relative to one another and by means of the respective number of windings such that the differential alternating voltage (UD) becomes zero at the required response distance, and that the differential alternating voltage (UD) at the input (16) of the oscillator amplifier (7) is fed back such that when the differential alternating voltage is zero, the oscillator (1) changes its oscillation state discontinuously.

2. Proximity switch according to Claim 1, characterised in that the transmitting coil (2) is connected as the inductance of the LC oscillating circuit (4) of the oscillator (1), that the input (16) of the oscillator amplifier (7) has high impedance and that the two sensor coils (12, 13) are connected with opposite polarisation in series between a voltage divider (14) and the high-impedance input (16) of the oscillator amplifier (7).

3. Proximity switch according to Claim 1, characterised in that the oscillator amplifier (80) is a two-stage transistor amplifier with an input transistor (81) and an output transistor (82), that the transmitting coil (63) is connected as the inductance of the LC oscillating circuit (4) of the oscillator (79) and is located in the collector circuit of the output transistor (82), and that the two sensor coils (64, 65) are connected with opposite polarisation in series between the base (84) of the input transistor (81) and the emitter (85) of the output transistor (82).

4. Proximity switch according to Claims 1, 2 or 3, characterised in that the oscillator (1, 79) is designed for an operating frequency of more than 20 kHz, preferably between 50 kHz and 1 MHz, and the sensor coils (12, 13) are constructed by means of their spatial position relative to one another and by means of the respective numbers of windings such that the differential alternating voltage (UD) becomes zero at the same switching distance both in the case of a tripping device (25, 46, 56) made of ferrous as well as non-ferrous metal.

5. Proximity switch according to Claims 1, 2 or 3, characterised in that the oscillator (1, 79) is designed for an operating frequency between preferably 1 kHz and 10 kHz and the sensor coils (12, 13; 64, 65) are constructed by means of their spatial position relative to one another and by means of the respective numbers of windings such that the differential alternating voltage (UD) only becomes zero when a ferrous tripping device approaches close to the required switching distance, while the differential alternating voltage never becomes zero over the entire possible tripping device approach range on the approach of a non-ferrous metal part.

6. Proximity switch according to Claims 1, 2 or 3, characterised in that the oscillator (1, 79) is designed for an operating frequency between preferably 1 kHz and 10 kHz and the sensor coils (12, 13; 64, 65) are constructed by means of their spatial position relative to one another and by means of the respective numbers of windings such that the differential alternating voltage (UD) only becomes zero on approach of a non-ferrous tripping device but not on approach of a ferrous metal part.

7. Proximity switch according to one of the Claims 1 to 6, characterised in that the transmitting coil (20) and the two sensor coils (23, 24) are arranged coaxially to one another.

8. Proximity switch according to Claim 7, characterised in that the transmitting coil (20) is arranged in a ferrite pot (21) with a central core (22) and both sensor coils (23, 24) are arranged in front of the ferrite pot (21) on the side of the tripping device (25).

9. Proximity switch according to Claim 7, characterised in that the transmitting coil and one of the sensor coils are wound in bifilar manner and that the bifilar winding (26) is arranged inside the ferrite pot (27).

10. Proximity switch according to Claim 9, characterised in that the other sensor coil (29) is arranged in front of the ferrite pot (27).

11. Proximity switch according to Claim 9, characterised in that the other sensor coil (35 or 31) likewise in the ferrite pot (37 or 33) is arranged either concentrically to the bifilar winding (34) of the first sensor coil and the transmitting coil or axially beside the bifilar winding (30).

12. Proximity switch according to Claim 7, characterised in that the transmitting coil (42) is arranged between the two sensor coils (43, 44) inside a tube (45).

13. Proximity switch according to Claims 1 and 6, characterised in that the two sensor coils (40, 41) are located with their ring planes in a plane and that the sensor coils (40, 41) enclose the transmitting coil (38) centrally between them.

14. Proximity switch according to Claim 7, characterised in that the transmitting coil (47) and the two sensor coils (48, 49) are arranged as air core coils coaxially on a common coil former (53) made of plastic or ceramic.

15. Proximity switch according to Claim 14, characterised in that the transmitting coil (47) is arranged centrally between the two sensor coils (48, 49).

16. Proximity switch according to Claim 15, characterised in that the transmitting coil (57) is axially displaceable.

**17.** Proximity switch according to Claims 14, 15 or 16, characterised in that a magnetic material part (54) with known temperature-dependent permeability behaviour is introduced into the field of the sensor coils (48, 49) for compensating for the temperature drifts occurring at large coil spacings.

**18.** Proximity switch according to Claim 17, characterised in that the magnetic material part (54) is attached in a recess (55) of the coil former (53) in the region of the sensor coil (49) facing away from the tripping device (56).

**19.** Proximity switch according to Claim 18, characterised in that the magnetic material part (54) has a surface area of 4 mm$^2$ at a coil diameter of 30 mm.

**20.** Proximity switch according to one of the preceding Claims 1 to 19, characterised in that the coils (63, 64, 65) are arranged in a metal screen (66) open towards the tripping device (56).

**21.** Proximity switch according to Claim 20, characterised in that on the open side of the metal screen (66) a compensation coil (68) is arranged concentrically and connected in series to the transmitting coil (63) so that the direction of the current (I1) in the compensation coil (68) is opposite to the direction of the current (I2) in the transmitting coil (63).

**22.** Proximity switch according to Claim 20, characterised in that the number of windings $n_K$ of the compensation coil (68) amounts approximately to 5% of the number of windings $n_s$ of the transmitting coil (63) multiplied by the ratio of the current (I2) in the transmitting coil to the current (I1) in the compensation coil, ie $n_K = 0.05 \times I1/I2 \times n_S$.

**23.** Proximity switch according to one of the preceding Claims 1 to 22, characterised in that the coils (73, 74, 75) are arranged in a one-piece, pot-shaped metal housing (69) closed towards the tripping device (56).

**24.** Proximity switch according to Claim 23, characterised in that at an oscillator frequency of between 1 kHz and 10 kHz, the wall thickness (S) of the metal housing (69) is smaller in the region (78) of the field emerging towards the tripping device (56) than the skin depth at the given operating frequency.

**25.** Proximity switch according to Claim 24, characterised in that the metal housing (69) consists of a metal of low permeability conducting electricity poorly, eg of titanium, V2A or V4A steel.

**Revendications**

**1.** Détecteur de proximité inductif équipé d'un oscillateur (1) alimentant une bobine émettrice (2) qui génère un champ magnétique alternatif, l'oscillateur (1) étant influencé dans son état d'oscillation par un déclencheur (25) métallique pénétrant dans le champ alternatif, et d'un circuit d'analyse (8) pour obtenir un signal de commutation à partir de la variation de l'état d'oscillation, caractérisé en ce que dans le champ alternatif deux bobines de capteur (12, 13) sont disposées dans le circuit différentiel direct pour l'enregistrement de la différence des tensions (U1, U2) induites dans les deux bobines de capteur, en ce que les bobines de capteur (12, 13) sont conçues selon leur position réciproque dans l'espace et les nombres de spires respectifs de telle manière que la tension alternative différentielle (UD) devienne nulle à la distance de réponse souhaitée, et en ce que la tension alternative différentielle (UD) est ramenée à l'entrée (16) de l'amplificateur (7) de l'oscillateur (1) de telle façon que, pour une tension alternative différentielle nulle, l'oscillateur (1) modifie brusquement son état d'oscillation.

**2.** Détecteur de proximité selon la revendication 1, caractérisé en ce que la bobine émettrice (2) est montée comme inductance du circuit oscillant LC (4) de l'oscillateur (1), en ce que l'entrée (16) de l'amplificateur d'oscillateur (7) a une valeur ohmique élevée et en ce que les deux bobines de capteur (12, 13) avec une polarisation opposée sont montées en série entre un diviseur de tension (14) et l'entrée (16) de valeur ohmique élevée de l'amplificateur d'oscillateur (7).

**3.** Détecteur de proximité selon la revendication 1, caractérisée en ce que l'amplificateur d'oscillateur (80) est un amplificateur à transistors à deux étages avec un transistor d'entrée (81) et un transistor de sortie (82), en ce que la bobine émettrice (63) est montée comme inductance du circuit oscillant LC (4) de l'oscillateur (79) et se trouve dans le circuit collecteur du transistor de sortie (82) et en ce que les deux bobines de capteur (64, 65) avec une polarisation opposée sont montées en série entre la base (84) du transistor d'entrée (81) et l'émetteur (85) du transistor de sortie (82).

**4.** Détecteur de proximité selon l'une quelconque des revendications 1, 2 ou 3, caractérisé en ce que l'oscillateur (1, 79) est conçu pour une fréquence de service supérieure à 20 kHz, de préférence une fréquence comprise entre 50 kHz et 1 MHz, et en ce que les bobines de capteur (12, 13) sont conçues du fait de leur position respective dans l'espace et des nombres de spires respectifs de telle manière que la tension alternative différentielle (UD) devienne nulle pour un intervalle de commutation identique aussi bien pour un déclencheur (25, 46, 56) à base de métal ferreux que pour un déclencheur à base de métal non ferreux.

**5.** Détecteur de proximité selon l'une quelconque des revendications 1, 2 ou 3, caractérisé en ce que l'oscillateur (1, 79) est conçu pour une fréquence de service comprise de préférence entre 1 kHz et 10 kHz et en ce que les bobines de capteur (12, 13 ; 64, 65) sont conçues selon leur position respective dans l'espace et de par les nombres de spires respectifs de telle manière que la tension alternative différentielle (UD) devient nulle seulement si l'on approche un déclencheur à base de métal ferreux jusqu'à la distance de commutation souhaitée, tandis que la tension alternative différentielle ne devient jamais nulle sur l'ensemble de la plage d'amorçage possible du déclencheur si l'on approche une partie de métal non ferreux.

**6.** Détecteur de proximité selon l'une quelconque des revendications 1, 2 ou 3, caractérisé en ce que l'oscillateur (1, 79) est conçu pour une fréquence de service comprise de préférence entre 1 kHz et 10 kHz, et en ce que les bobines de capteur (12, 13 ; 64, 65) sont conçues selon leur position respective dans l'espace et selon les nombres de spires respectifs de telle façon que la tension alternative différentielle (UD) ne devienne nulle que si l'on approche un déclencheur à base de métal non ferreux mais pas si l'on approche une partie en métal ferreux.

**7.** Détecteur de proximité selon l'une quelconque des revendications 1 à 6, caractérisé en ce que la bobine émettrice (20) et les deux bobines de capteur (23, 24) sont disposées sur le même axe.

**8.** Détecteur de proximité selon la revendication 7, caractérisé en ce que la bobine émettrice (20) est disposée dans un pot en ferrite (21) avec support central (22) et en ce que les deux bobines de capteur (23, 24) sont disposées en amont du pot en ferrite (21) du côté du déclencheur (25).

**9.** Détecteur de proximité selon la revendication 7, caractérisé en ce que la bobine émettrice et l'une des bobines des capteurs ont un enroulement bifilaire et en ce que l'enroulement bifilaire (26) est disposé à l'intérieur du pot en ferrite (27).

**10.** Détecteur de proximité selon la revendication 9, caractérisé en ce que l'autre bobine de capteur (29) est disposée en amont du pot en ferrite (27).

**11.** Détecteur de proximité selon la revendication 9, caractérisé en ce que l'autre bobine de capteur (35 ou 31) est disposée également dans le pot en ferrite (37 ou 33) soit de façon concentrique par rapport à l'enroulement (34) bifilaire de la première bobine de capteur et de la bobine émettrice soit sur l'axe à côté de l'enroulement (30) bifilaire.

**12.** Détecteur de proximité selon la revendication 7, caractérisé en ce que la bobine émettrice (42) est disposée entre les deux bobines de capteur (43, 44) à l'intérieur d'un tube (45) .

**13.** Détecteur de proximité selon la revendication 1 et 6, caractérisé en ce que les deux bobines de capteur (40, 41) se trouvent avec leurs plans annulaires dans un seul plan et en ce que les bobines de capteur (40, 41) entourent la bobine émettrice (38) au milieu entre elles.

**14.** Détecteur de proximité selon la revendication 7, caractérisé en ce que la bobine émettrice (47) et les deux bobines de capteur (48, 49) se présentent sous la forme de bobine à couplage dans l'air et sont disposées sur le même axe sur un corps de bobine (53) commun à base de plastique ou de céramique.

**15.** Détecteur de proximité selon la revendication 14, caractérisé en ce que la bobine émettrice (47) est disposée au centre entre les deux bobines de capteur (48, 49).

**16.** Détecteur de proximité selon la revendication 15, caractérisé en ce que la bobine émettrice (57) peut être déplacée sur l'axe.

**17.** Détecteur de proximité selon l'une quelconque des revendications 14, 15 ou 16, caractérisé en ce qu'on introduit dans le champ des bobines de capteur (48, 49) une pièce à base de matériau magnétique (54) avec une perméabilité connue dépendante de la température afin de compenser les dérives de température qui apparaissent dans le cas de grands intervalles entre les bobines.

18. Détecteur de proximité selon la revendication 17, caractérisé en ce que la pièce à base de matériau magnétique (54) est disposée dans une cavité (55) du corps de bobine (53) dans la zone de la bobine de capteur (49) opposée au déclencheur (56).

19. Détecteur de proximité selon la revendication 18, caractérisé en ce que la pièce à base de matériau magnétique (54) présente une surface de 4 mm2 pour un diamètre de bobine de 30 mm.

20. Détecteur de proximité selon l'une quelconque des revendications précédentes 1 à 19, caractérisé en ce que les bobines (63, 64, 65), sont disposées dans une protection métallique (66) ouverte en direction du déclencheur (56).

21. Détecteur de proximité selon la revendication 20, caractérisé en ce que, du côté ouvert de la protection métallique (66), une bobine de compensation (68) est disposée de façon concentrique et est montée en série avec la bobine émettrice (63), de sorte que le sens du courant (I 1) dans la bobine de compensation (68) est opposé au sens du courant (I 2) circulant dans la bobine émettrice (63).

22. Détecteur de proximité selon la revendication 20, caractérisé en ce que le nombre de spires nK de la bobine de compensation (68) est égale à environ 5 % du nombre de spires nS de la bobine émettrice (63) multiplié par le rapport entre le courant de la bobine émettrice (I2) et le courant de la bobine de compensation (I1), c'est-à-dire $n_K = 0{,}05 \times \frac{I1}{I2} \times n_S$.

23. Détecteur de proximité selon l'une quelconque des revendications précédentes 1 à 22, caractérisé en ce que les bobines (73, 74, 75) sont disposées dans un boîtier métallique (69) d'un seul tenant, fermé en direction du déclencheur (56) et en forme de pot.

24. Détecteur de proximité selon la revendication 23, caractérisé en ce que, pour une fréquence d'oscillateur comprise entre 1 kHz et 10 kHz, l'épaisseur de paroi (S) du boîtier métallique (69) dans la zone (78) du champ sortant en direction du déclencheur (56) est inférieure à la profondeur de peau pour une fréquence de service donnée.

25. Détecteur de proximité selon la revendication 24, caractérisé en ce que le boîtier métallique (69) est à base d'un métal à mauvaise conduction électrique et faible perméabilité, par exemple à base de titane, d'acier V2A ou d'acier V4A.

_Fig.1_

_Fig.2_

_Fig.3_

_Fig.4_

_Fig.5_

_Fig.6_

_Fig.7_

*Fig. 8*

*Fig. 9*

*Fig. 10*

_Fig.11_

_FIG. 13_

Fig.12